# EUROPÄISCHE PATENTSCHRIFT

(11) **EP 1 043 923 B1**
(45) Veröffentlichungstag und Bekanntmachung des Hinweises auf die Patenterteilung: **14.08.2002**
(21) Anmeldenummer: 00107294.1
(22) Anmeldetag: 04.04.2000
(51) Int. Cl.: H05K 9/00, H04L 9/00

(54) **Trust-Center-Einheit**
Trust centre unit
Unité de centre d'authentification

(30) Priorität: 07.04.1999 DE 19915668
(43) Veröffentlichungstag der Anmeldung: 11.10.2000
(73) Patentinhaber: TüV Süddeutschland Bau und Betrieb GmbH, 80686 München (DE)
(72) Erfinder: Langer, Gerhard, 82256 Fürstenfeldbruck (DE); Dafelmair, Ferdinand, 81379 München (DE)
(74) Vertreter: Grättinger & Partner (GbR)

(56) Entgegenhaltungen:
- EP-A- 0 381 273
- EP-B- 0 151 714
- DE-A- 3 023 427
- DE-C- 3 916 079
- DE-C- 19 647 757
- FR-A- 2 385 874
- US-A- 4 794 206
- US-A- 5 749 178

## Beschreibung

Die Erfindung betrifft eine Trust-Center-Einheit (TCE) mit einer Sicherheitszelle für den Betrieb einer Public-Key-Infrastruktur (PKI), welche eine Chipkarten-Personalisierungseinrichtung (CPE) umfaßt.

Dem Begriff nach versteht man unter einem Trust Center die Zertifizierungsstelle einer Public-Key-Infrastruktur, die elektronische Schlüsselzertifikate für asymmetrische Verschlüsselungsverfahren erzeugt, in denen die Zuordnung zwischen den darin enthaltenen elektronischen Schlüsseln und natürlichen Personen oder anderen Bezugsgrößen bestätigt wird.

Einem derartigen Trust Center kommt also die mit hoher Vertrauenswürdigkeit verbundene Aufgabe zu, digitale Signaturen nach den bestehenden Rechtsvorschriften des Signaturgesetzes (SigG) zuverlässig zu ermöglichen.

Gemäß § 2 SigG ist eine digitale Signatur ein mit einem privaten Signaturschlüssel erzeugtes Siegel zu digitalen Daten, das mit Hilfe eines zugehörigen öffentlichen Schlüssels, der mit einem Signaturschlüssel-Zertifikat einer Zertifizierungsstelle versehen ist, den Inhaber des Signaturschlüssels und die Unverfälschheit der Daten erkennen läßt.

Eine derartige Zertifizierungsstelle, welche die Zuordnung von öffentlichen Signaturschlüsseln zu natürlichen Personen bescheinigt, erfüllt ihre Aufgabe mit Hilfe eines Trust Centers der gegenständlichen Art gewissermaßen als zentrale Instanz für alle Teilnehmer einer Public-Key-Infrastruktur (PKI). Neben der genannten Tätigkeit im Zusammenhang mit der Ausstellung von Schlüsselzertifikaten versorgt ein Trust Center die Teilnehmer einer PKI mit personalisierten Chipkarten, mit denen jeder Teilnehmer seinen geheimen privaten Schlüssel, mit dem er digital signiert, geheim und sicher aufbewahren und verwenden kann.

Wegen der sicherheitsrelevanten Arbeitsabläufe in einem Trust Center werden an dessen konkrete Ausgestaltung Anforderungen gestellt, wie sie beispielsweise für hochsichere Rechenzentren üblicherweise gelten. Um sicherzustellen, daß die geheimen Signierschlüssel des Trust Centers nicht kompromittiert werden können, die Technik zur Generierung der Schlüssel keinem fremden Einfluß ausgesetzt werden kann, die erzeugten privaten Schlüssel der Teilnehmer der PKI nicht kompromittiert werden können und die Informationen eines zu signierenden Zertifikats nicht unzulässig verändert werden können, ist ein Trust Center nach herkömmlicher Auffassung in Räumen zu errichten, welche über gepanzerte Wände, wie beispielsweis in DE 4322262 C2 beschrieben, die einen hohen Durchbruchswiderstand bieten, sowie über bauliche Schutzmaßnahmen wie verstärkte Mauern und Decken sowie einbruchsichere Fenster und Türen verfügen. Der Stand der Technik sieht außerdem eine strikte technische Zugangskontrolle für dort arbeitende Personen vor. Dahinter steht die Vorstellung, daß die erforderliche Absicherung gegen jegliche Art von Mißbrauch umfangreiche Abschirmmaßnahmen in den Räumen des Trust Centers erforderlich macht, so daß mögliche Angreifer auf Distanz gehalten werden, ihnen insbesondere keine Möglichkeit gegeben wird, die elektromagnetische Abstrahlung der elektronischen Einrichtungen des Trust Centers gegen die Interessen der Teilnehmer in der PKI auszuspähen.

Damit ein Trust Center als Vertrauensstelle allgemeine Akzeptanz finden kann, ist eine individuelle Evaluierung derartiger Trust Center durch die zuständigen Aufsichtsbehörden vorgesehen. Eine solche Evaluierung beinhaltet die technische Ausstattung, die angewendeten Verfahren und Betriebsprozesse sowie die baulichen Infrastrukturmaßnahmen.

Nach dem gegenwärtigen technischen Stand erfordert die Realisierung eines Trust Centers aufwendige bauliche Absicherungsmaßnahmen. Dies bedingt nicht nur hohe Investitionskosten sondern auch hohe Betriebskosten für die ständige Überwachung und Absicherung des Bauwerks.

Bei der Schlüsselgenerierung spielt außerdem die manuelle Interaktion aus Sicherheitsgründen eine große Rolle, wobei unvermeidlich ist, daß das Bedienungspersonal direkt Zugriff auf die angewandten Systeme erhält und diese damit auch manipulieren könnte.

Demgegenüber liegt der vorliegenden Erfindung die Aufgabe zugrunde, ein Trust Center zu schaffen, welches mit geringerem materiellem und personellem Aufwand geschaffen und betrieben werden kann, dabei aber gleichzeitig die Sicherheit gegenüber dem Standard bei bekannten Hochsicherheitsrechenzentren zu steigern. Insbesondere soll erreicht werden, daß zum Betrieb der Chipkarten-Personalisierungseinrichtung kein qualifiziertes oder besonders sicherheitsgeprüftes Personal erforderlich ist. Dabei soll der Betrieb eines Trust Centers auch unter normalen Umgebungsbedingungen eines Büros erfolgen können.

Diese Aufgabe wird gemäß Patentanspruch 1 im Sinne einer Kombination baulicher und softwareorientierter Merkmale gelöst, wobei letztere insbesondere durch den Einsatz von Rechnersystemen und geeigneter Software erzielt werden. Da bei den baulichen Merkmalen der neue Weg der Leichtbauweise gewählt wird, die es ermöglicht, eine Trust-Center-Einheit beinhaltende Sicherheitszellen praktisch in jedem Büroraum zu errichten, sind zusätzlich neben Überwachungssensoren zum Erkennen physischen Eindringens, dem Abschirmschutz gegen Durchgang elektromagnetischer Wellen in beiden Richtungen dienende Maßnahmen erforderlich; dabei sind in dem überwachten Einbauraum alle sicherheitskritischen Funktionsmodule der TCE untergebracht, auch solche, die wie die Chipkarten-Personalisierungseinrichtung einen Zugang von außen benötigen.

Eine geeignete Hülle für eine Sicherheitszelle, welche den vorgenannten Ausgestaltungsmerkmalen genügt, ist im einzelnen in den Unteransprüchen 2 bis 9 beansprucht.

Demzufolge handelt es sich um eine aus zwei oder mehreren Schalen zusammengesetzte Hülle, jeweils bestehend aus eine Seitenwand bildenden Wandelementen, einem Boden- und einem Deckenelement.

Um mit einer möglichst kleinen Grundfläche auszukommen und in üblichen Büroräumen ein Umlaufen der Sicherheitszelle zu erleichtern, ist es vorteilhaft, die Hülle mit einem Achteck-Grundriß zu gestalten, wobei die Seitenwand aus diesem zugeordneten Wandelementen besteht.

Bei einer bevorzugten Ausführungsform besteht die Hülle aus einer Außenschale und einer Innenschale jeweils aus hochfestem Aluminium, wobei die Schalen durch in der Fläche der Wandelemente verteilt angeordnete Abstandsbolzen oder geeignete Abstandsgitter, die beispielsweise aus Hohlprofilen zusammengeschweißt oder aus dem Vollen gefräst sind, gegeneinander abgestützt sind.

Bei der Konstruktion der Außenschale ist zweckmäßig darauf zu achten, daß diese eine möglichst geschlossene Oberfläche aufweist. Darunter ist beispielsweise zu verstehen, daß die Verbindungselemente zwischen vertikalen Profilträgern in den Eckbereichen der Seitenwand und den angrenzenden Wandelementen oder Verbindungsmittel zwischen dem Bodenelement und dem Dachelement einerseits und der Seitenwand andererseits nur von innen zugänglich sind, also nicht nach außen durchgeführt sind.

In diesem Sinne wird noch vorgeschlagen, daß CPE, Tür und Access-Modul jeweils einem von zwei Ecken begrenzten Wandelement der Seitenwand zugeordnet sind; auf diese Weise können die dabei erforderlichen Öffnungen in Bezug auf ihre Unversehrtheit besser kontrolliert werden. Gleiches gilt für die Gestaltung der Oberfläche der Hülle, die im wesentlichen aus ebenen Flächen zusammengesetzt sein sollte und bevorzugt zur besseren optischen Erkennung ihrer Unversehrtheit hochglanzbehandelt sein kann.

Die Hülle, welche die Sicherheitszelle bildet, kann eine Türe aufweisen, um den Zugriff zu deren Einbauten durch eine Bedienungsperson zu gewährleisten. Es sind aber auch Ausführungsformen mit kleineren Öffnungen denkbar, wenn dafür gesorgt ist, daß Einbauten zur Gewährleistung des Zugriffs zum Zwecke der Wartung, der Erneuerung oder dgl. durch die Hülle aus - und eingefahren werden können.

Nach einem weiteren Erfindungsvorschlag ist der Zwischenraum der doppelwandigen Metallschale der geeignete Raum für die Unterbringung von Einrichtungen für die Abschirmung einer derartigen Sicherheitszelle.

Eine in diesem Sinne geeignete, flächig wirksame Detektionseinrichtung besteht aus einem Plattenkondensator, der aus einzelnen Plattenelementen zusammengesetzt ist, welche derart angeordnet sind, daß sie ein lückenloses elektrisches Feld aufbauen, welches im Falle einer Penetrierung eines Plattenelements einen meßbaren Stromfluß erzeugt. Die dabei abgeleiteten Signale ermöglichen dann die weiter unten noch erläuterte Sicherheitsabschaltung der TCE.

Eine zusätzliche, besonders vorteilhafte Überwachungsmöglichkeit besteht darin, daß der Schalenzwischenraum gasdicht ausgebildet ist und dort ein Unterdruck aufrechterhalten wird, und daß im Zwischenraum Drucksensoren vorgesehen sind. Dabei kann der Zwischenraum ganz oder teilweise mit einem inerten Gas, z.B. Neon, gefüllt sein, wobei ein Abfluß von Gasmolekülen durch Gasdrucksensoren und Gassensoren besonders wirksam überwacht werden kann.

Im Falle einer Unterdrucküberwachung im Schalenzwischenraum bei gleichzeitiger Anwesenheit des oben erläuterten Plattenkondensators sind die Abstandsbolzen zwischen der Außen- und der Innenschale der Hülle zweckmäßig geteilt in Abschnitte zwischen Innenschale und Plattenelement und weitere Abschnitte zwischen Außenschale und Plattenelement. Infolge des herrschenden Unterdrucks werden die Abstandsbolzen auf Druck beansprucht, wobei die Plattenelemente zwischen deren äußeren und inneren Abschnitten ohne besondere Verbindungselemente fixiert werden. Anstelle der Bolzen können auch geeignete Abstandsgitter auf beiden Seiten der Plattenelemente eingefügt sein.

Wegen der besonders hohen Sicherheitsanforderungen ist es ferner zweckmäßig, daß bei Leitungsdurchführungen in die Sicherheitszelle die Adern elektrischer Kabel auf Adernbruch, mediengefüllte Leitungen auf Druckschwankungen und/oder durch optische Sensoren überwacht werden. Auch eine Körperschallüberwachung mittels über die Innenschale verteilt angeordneter Sensoren kann zweckmäßig sein. Eine hochwirksame elektromagnetische Abschirmung wird gefördert durch versetzte Leitungsführungen zwischen der Durchdringung der Innen- und Außenschale in Form von Labyrinthanordnungen.

Anstelle der Plattenkondensatoren, die sowohl als Überwachungssensoren als auch dem Abschirmschutz dienen können, besteht die alternative Möglichkeit, neben separaten Sensoren zur Penetrationsüberwachung einfache Platten aus Stahl oder anderen ferromagnetischen Materialien oder Folien aus hochpermeablen ferromagnetischen Materialien vorzusehen, welche eine wirksame Abschirmung gegen elektromagnetische Abstrahlung einerseits und gegen Beeinflussung durch elektromagnetische Einstrahlung andererseits bilden, stets vorausgesetzt, daß die Platten mit dem Ziel einer lückenlosen Abschirmung verlegt sind, z.B. indem diese überlappend angeordnet werden.

Wie bereits angedeutet bedürfen die vorstehend erläuterten physikalischen Sicherheitsmaßnahmen noch einer Ergänzung durch eine entsprechende Ausgestaltung der eingesetzten Software auf hierfür geeigneten Überwachungssystemen.

Die erfindungsgemäße TCE besteht im wesentlichen aus den folgenden Submodulen, die z.T. mehrfach in der Trust-Center-Einheit eingebaut sein können.
1. Certification Module (Cert-Modul)
2. Personalization Module (Pers-Modul)
3. Control and Security Module (Control/Sec-Modul)
4. Time Stamp Module (Timestamp-Modul)
5. Verification Module (Verify-Modul)
6. Secure Communication Module (Sec/Comm-Modul)
7. Supply Module (Stromversorgung, Klimatisierung, Vakuum)
8. Directory Module (optional)

Die genannten Funktionsmodule sind in der Sicherheitszelle untergebracht. Die zu personalisierenden Hardware-Token, insbesondere Chipkarten werden von außen manuell zugeführt, in der Trust-Center-Einheit bearbeitet und wieder nach außen abgegeben. Die Sicherheitszelle ist für Wartungsarbeiten begehbar, im Betrieb jedoch menschenleer, und arbeitet vollautomatisch. Die TCE besitzt eine Anbindung an das Kommunikationsnetz der zu ihr gehörigen PKI und stellt die Funktionen Schlüsselgenerierung, Zertifikatserstellung, elektrische Personalisierung von Hardware-Token, insbesondere Chipkarten, Zeitstempeldienst und Zertifikatsprüf- und -sperrdienst zur Verfügung. Ein Verzeichnisdienst zur Abfrage von Zertifikaten kann optional in der TCE mit integriert sein, wird bevorzugt jedoch außerhalb der TCE betrieben.

Das Pers-Modul umfaßt die sog. Chipkarten-Personalisierungseinrichtung (CPE) und die dazugehörige Steuerung. In der CPE findet das elektrische Personalisieren von Chipkarten in sog. Kontaktierstellen statt, wobei jede dieser Kontaktierstellen über einen Chipkarten-Coupler mit einem sog. Crypto-Modul verbunden ist. Werden andere Hardware-Token als Chipkarten verwendet, so wird eine entsprechend geeignete Personalisierungseinrichtung verwendet. In den Crypto-Modulen laufen alle sicherheitskritischen Funktionen bei der Personalisierung einer Chipkarte ab. Mehrere dieser Crypto-Module sind dabei in ein Cert-Modul eingebaut, welches auf der Basis eines Industrierechners aufgebaut ist. Einer Personalisierungsmaschine können mehrere Cert-Module zugeordnet sein. Die Funktionen der Crypto-Module sind dabei gegen unzulässige Beeinflussung durch den Host-Rechner der Cert-Module abgeschottet, ihre Funktionen werden jedoch durch den Host-Rechner über eine sehr schmal ausgeführte datentechnische Schnittstelle angestoßen und mit den zu verarbeitenden Daten versorgt. Das Cert-Modul ist mit einem lokalen Security-Modul (SM) ausgestattet, welches im Falle einer Störung des ordnungsgemäßen Betriebs, signalisiert durch das Signal "Sicherheitsabschaltung", alle Crypto-Module des Cert-Moduls in einen den Schutzzielen des Trust Centers entsprechenden sicheren Zustand versetzt, d.h. die Signierschlüssel liegen nur noch verschlüsselt vor und die Arbeitsspeicher der Crypto-Module sind gelöscht. Gleiches gilt für die Crypto-Module in den Funktionsmodulen Timestamp-Modul und Verify-Modul, welche ebenfalls mit Signierschlüsseln des Trust Centers ausgestattet sind.

In diesem Sinne wird erfindungsgemäß vorgeschlagen,
- daß die Crypto-Module ein autark arbeitendes Rechnersystem mit Spezialhardware und Sicherungsfunktionen bilden, welches für den Betrieb aller sicherheitskritischen Operationen, nämlich Schlüsselerzeugung, Einbringen der Schlüssel in Chipkarten, Signatur der Schlüsselzertifikate, Anbringen von Zeitstempeln und Verifikation von Teilnehmer-Registrierungsdaten vorgesehen ist,
- daß die Crypto-Module über ihre Schnittstellen zum Funktionsmodul, in dem sie eingebaut sind, mit diesem datentechnisch kommunizieren, ohne jedoch über diese Kommunikations-schnittstellen in ihrer spezifikationsgemäßen Funktionsweise beeinflußt zu werden und
- daß die Sicherungsfunktionen des Crypto-Moduls abhängig vom Signal "Sicherheitsabschaltung" oder von der Abschaltung der Spannungsversorgung, das Crypto-Modul unbrauchbar machen, wobei die darin gespeicherten Signierschlüssel dann nur mehr verschlüsselt vorliegen oder gelöscht werden.

Erfindungsgemäß können weitere Abschirmmaßnahmen darin bestehen, daß die Crypto-Module als solche mit Metall-Abschirmungen versehen sind, und daß die CPE, in der die Teilnehmerschlüssel auf die Chipkarte geschrieben werden, sowie die Funktionsmodule, z.B. das Cert-Modul, das Verify-Modul und das Timestamp-Modul, in denen Crypto-Module verwendet werden, die ihrerseits Signierschlüssel des Trust Centers gespeichert halten und verwenden, als Gesamtheit mit einer Metall-Abschirmkapsel umgeben sind, wobei alle Kommunikationsleitungen mit Filtern gegen leitungsgebundene elektromagnetische Felder versehen sind, so daß sich ein gestaffelter Schutz gegen Abstrahlung elektromagnetischer Felder ergibt.

Als weitere hardwareorientierte Sicherheitsmaßnahme ist vorgesehen, daß zur Überprüfung der Integrität der in der Sicherheitszelle angeordneten Funktionsmodule deren Hardware mit Plomben für eine Sichtprüfung auf Unversehrtheit und mit Chipkartenlesern für die Verifikation der Modulversionen anhand der eingebrachten Gerätezertifikate sowie zur Verifikation zumindest der sicherheitskritischen Software versehen sind, so daß eine Identifikation und Authentisierung der Funktionsmodule erfolgen kann und ihre Integrität unter Einbeziehung ihrer Software bei geöffneter Tür der Sicherheitszelle festgestellt werden kann.

Als weitere zusätzliche oder alternative Sicherungsmaßnahme ist vorgesehen, die Software der sicherheitskritischen Komponenten nach einer Öffnung der TCE neu einzuspielen.

Zum Zwecke der Zugangskontrolle an der Tür der Sicherheitszelle kann als weitere Sicherheitsmaßnahme vorgesehen sein, daß sich die Tür nur dann bestimmungsgemäß öffnen läßt, wenn zwei Sicherheitspersonen ihre persönliche Chipkarte in ein Access-Modul stecken, einen persönlichen Code eingeben und eine Identifizierung durch ein biometrisches Verfahren durchführen, andernfalls bei Öffnungsversuchen die Sicherheitsabschaltung eingeleitet wird, und daß nach einer Wiederkehr der Energieversorgung gesichert festzustellen ist, ob die Tür seit dem letzten ordnungsgemäßen Betrieb geöffnet wurde.

Ein Control and Security-Module (Control/Sec-Modul) ist für die Sicherheitsüberwachung und die physische Zugangskontrolle der TCE zuständig. Es ist mit einem zusätzlichen mechanischen Schutz versehen, so daß Manipulationen an diesem Modul auch bei geöffneter Sicherheitszelle erschwert und insbesondere erkannt werden können. Am Control/Sec-Modul sind alle Überwachungssensoren der TCE angeschlossen. Außerdem ist daran das außerhalb der Sicherheitszelle gelegene Access-Modul angeschlossen, welches über Chipkartenleser, ein Keypad und ein biometrisches Identifikationssystem verfügt. Über das Access-/Check-Modul wird das Trust-Center-Modul in Betrieb genommen und dort erfolgt auch die Authentisierung für den Zutritt in die Sicherheitszelle im Wartungsfall. Über einen Verriegelungsmechanismus stellt das Check-Modul sicher, daß das Trust-Center-Modul nur dann in Betrieb genommen wird, wenn sich keine Personen mehr in der Sicherheitszelle aufhalten, die Tür verriegelt ist, alle Sicherheitssysteme korrekt arbeiten und alle Produktionssysteme funktionsbereit sind.

Der Vollständigkeit halber sei noch darauf hingewiesen, daß das Timestamp-Modul den Zeitstempeldienst realisiert und hierzu die übermittelten Hash-Werte mit der Absolutzeit signiert, welche es aus einem Uhrzeit-Modul erhält. Letzteres enthält eine hochgenaue Uhr und bezieht zusätzlich Synchronisationsinformationen von einer externen Zeitbasis.

Schließlich sei noch das Verify Module erwähnt, welches die Verifikation der Gültigkeit von Zertifikaten ermöglicht und welches ferner ermöglicht, Zertifikate auf Anforderung zu sperren und entsprechende signierte Sperrlisten zur Verfügung stellt.

Für den Betrieb der TCE wie vorstehend erläutert und im Anspruch 1 definiert ergeben sich daher die folgenden Verfahrensabläufe.

Die TCE kann aufgrund eines eingebauten Verriegelungsmechanismus nur dann in Betrieb genommen werden, wenn es menschenleer ist, wenn alle Sicherheitsfunktionen korrekt arbeiten und keine Störungen an Funktionsmodulen detektiert werden; es kann nur dann ohne zusätzliche Verifikation der Integrität seiner Komponenten in Betrieb genommen werden, wenn die Tür seit dem Verlassen des ungestörten Betriebszustandes nicht geöffnet wurde.

Nach einem Öffnen der Tür oder Ansprechen der Überwachungssensoren kann die TCE nur dann in Betrieb gesetzt werden, wenn zuvor die Integrität und Authentizität der Hardware aller eingebauter Module festgestellt wurde und die Software zumindest aller sicherheitskritischen Funktionen durch Überprüfung ihrer MAC-Codes als korrekt verifiziert oder aus gesicherter Quelle neu eingespielt wurde. Bei jeglichem Ansprechen der Überwachungssensoren der TCE erfolgt eine Sicherheitsabschaltung der TCE.

Die elektrische Personalisierung von Personal Security Environments (PSE) auf der Basis von Hardware-Tokens, insbesondere Chipkarten, erfolgt in der TCE dadurch, daß asymmetrische Schlüsselpaare innerhalb der TCE unter kontrollierten Bedingungen in einer Spezialhardware abhörsicher erzeugt werden und in das Hardware-Token eingebracht werden, daß der geheime Schlüssel den seinen Besitzer kennzeichnenden Daten zugeordnet wird und diese Zuordnung in einem Zertifikat der TCE bestätigt wird, welches zumindest den korrespondierenden öffentlichen Schlüssel und die kennzeichnenden Daten des Besitzers enthält und in das Hardware-Token eingebracht wird. Dabei erfolgt die Zuführung und Abführung der Hardware-Token vollautomatisch von außerhalb der TCE, wobei für jedes Hardware-Token bei der Personalisierung ein eindeutiger Aktivierungscode generiert und in das Hardware-Token eingebracht wird, dessen Kenntnis erforderlich ist, um das Hardware-Token zu aktivieren. Von der TCE wird der Aktivierungscode gesichert und geheim dem Empfänger des Hardware-Tokens übermittelt. Die TCE generiert außerdem für jedes personalisierte Hardware-Token einen eindeutigen Sperrcode, der sowohl in der TCE gespeichert bleibt als auch dem Empfänger des Hardware-Tokens gesichert übermittelt wird.

Asymmetrische Schlüsselpaare werden in der TCE ausschließlich in einem speziellen Crypto-Modul unter kontrollierten Umgebungsbedingungen erzeugt, wobei die Generierung abhörsicher erfolgt; die geheimen Schlüssel werden in die Hardware-Token ebenfalls abhörsicher eingebracht, sobald sich ein zu personalisierendes Hardware-Token in der zugeordneten Kontaktierposition in der CPE befindet.

Außerdem prüft das Crypto-Modul für jedes erzeugte Schlüsselpaar, ob das Schlüsselpaar identisch mit einem vorher erzeugten ist, und aktiviert nach Übertragung der geheimen Schlüssel auf das Hardware-Token die Sicherheitsfunktionen des Hardware-Tokens gegen Auslesen und Überschreiben der Schlüssel. Das Verfahren ist weiterhin dadurch abgesichert, daß die für die Schlüsselerzeugung verwendeten flüchtigen Speicher im Crypto-Modul beim Ansprechen des Signals "Sicherheitsabschaltung" oder beim Abschalten der Versorgungsspannung zurückgesetzt werden.

Im Folgenden wird ein Ausführungsbeispiel der Erfindung anhand der Zeichnung erläutert. Es zeigt:
- Fig. 1: eine perspektivische Ansicht der Sicherheitszelle einer Trust-Center-Einheit,
- Fig. 2: die Hülle einer Sicherheitszelle im Grundriß,
- Fig. 3: in einer Schnittdarstellung längs einer vertikalen Ebene III-III;
- Fig. 4: die Einzelheit IV gemäß Fig. 3 und
- Fig. 5: die Einzelheit V gemäß Fig. 2 und
- Fig. 6: ein vereinfachtes Schaltbild der TCE.

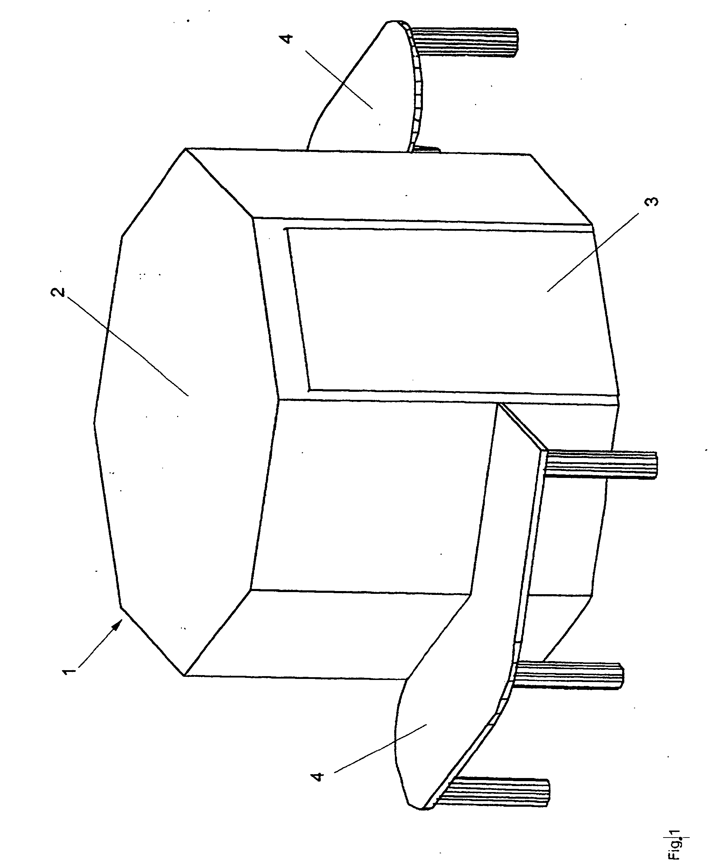

Fig. 1 zeigt die Sicherheitszelle 1 mit achteckiger Grundrißform, einem Dachelement 2, einer Tür 3 und seitlichen Ablagen 4 in Form von an der Außenseite der Seitenwand der Sicherheitszelle 1 angeschlossenen Tischen.

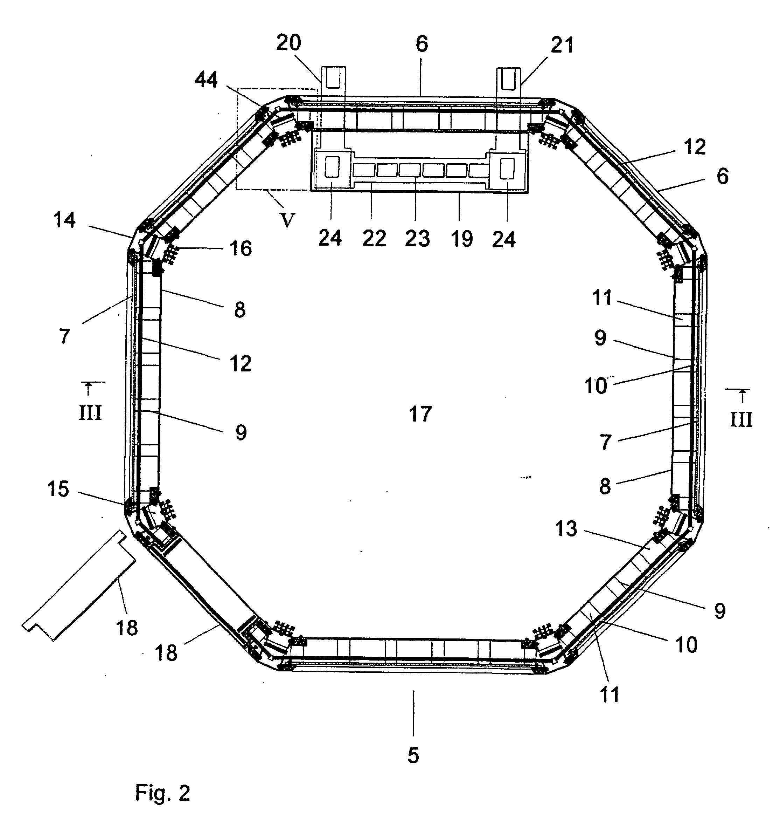

Fig. 2 zeigt als Horizontalschnitt durch eine die Sicherheitszelle 1 bildende Hülle 5, daß letztere einen achteckigen Grundriß beschreibt. Zwischen vertikalen Profilträgern in den Eckbereichen befinden sich Wandelemente 6, welche jeweils zweischalig aufgebaut sind, nämlich aus einer Außenschale 7 und einer Innenschale 8. Die beiden Schalen sind gegenseitig abgestützt durch eine Mehrzahl von Bolzen 9, welche durch eine im Schalenzwischenraum angeordnete flächige Abschirmung in einen äußeren Abschnitt 10 und einen inneren Abschnitt 11 geteilt sind. Diese Abschirmung besteht aus metallischen Abschirmplatten 12, welche zusätzlich zu den Bolzen 9 in den Eckbereichen fixiert sind. Die Bolzen 9 sind über die Gesamtfläche der Wandelemente verteilt angeordnet, um für den Fall, daß der Zwischenraum 13 zwischen Außenschale 7 und Innenschale 8 evakuiert wird, eine ausreichende Abstützung zu gewährleisten. Ein für die Sicherheitsüberwachung geeigneter Druck im Zwischenraum 13 beträgt zwischen 100 und 500 mbar. Der Unterdruck herrscht demzufolge auf beiden Seiten der Abschirmplatten 12.

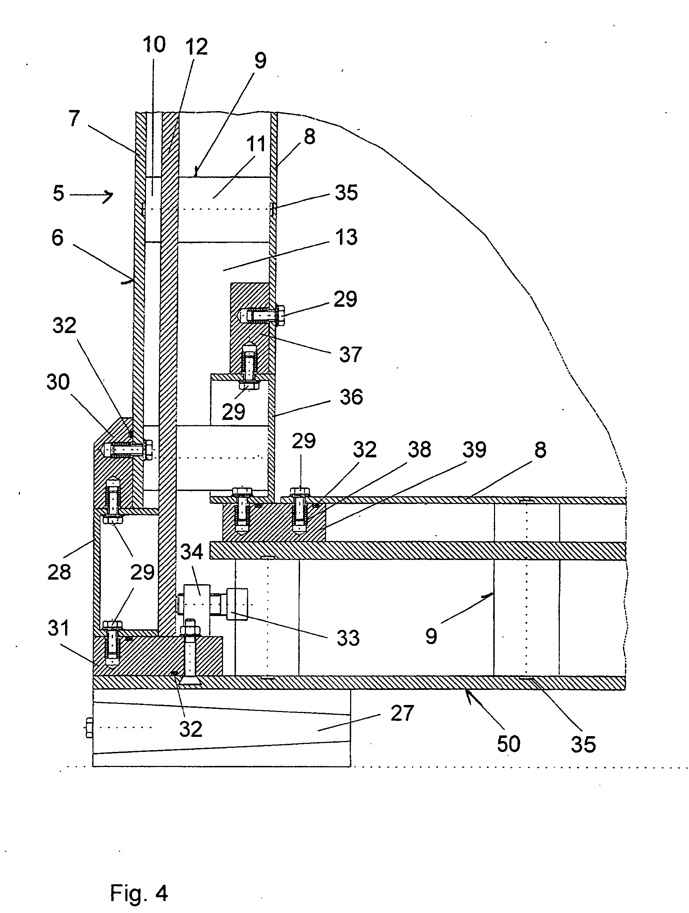

Die Eckbereiche werden gebildet durch einen äußeren U-Profilträger 14 und einen inneren U-Profilträger 15, an welche die Außenschale 7 bzw. die Innenschale 8 über geeignete Verbindungsleisten (vgl. Fig. 4) gasdicht angeschlossen sind. Entlang des Steges des inneren U-Profilträgers 15 ist ein vertikal verlaufendes Montageprofil 16 zur Fixierung der Einbauten im Innenraum 17 der Hülle 5 befestigt. In diesen Innenraum 17 führt eine Sicherheitstür 18, welche ebenfalls doppelwandig ausgebildet ist und welche strichliert in der abgehobenen bzw. geöffneten Position dargestellt ist. Im normalen Betrieb ist die Tür geschlossen und gesichert.

Im Inneren der Sicherheitszelle befinden sich keine Bedienungspersonen; dort laufen sämtliche Operationen vollautomatisch ab. Ein Öffnen der Tür 18 kommt also nur für den Störfall bzw. Wartungsfall in Frage.

Schließlich erkennt man auf der linken Seite der Darstellung gemäß Fig. 2 die Chipkarten-Personalisierungseinrichtung 19 mit durch das zugeordnete Wandelement 6 hindurchgeführten Zuführkanal 20 und Ausgabekanal 21. Im Innenraum 17 befindet sich der Kontaktierkanal 22 der Personalisierungseinrichtung 19, längs welchem sechs Chipkarten 23 zum Zwecke des elektrischen Personalisierens mit dem persönlichen Schlüssel aufgereiht sind. In den Eckbereichen 24 des Kontaktierkanals 22 werden die Chipkarten durch eine geeignete Umsetzeinrichtung jeweils um 90° umgesetzt.

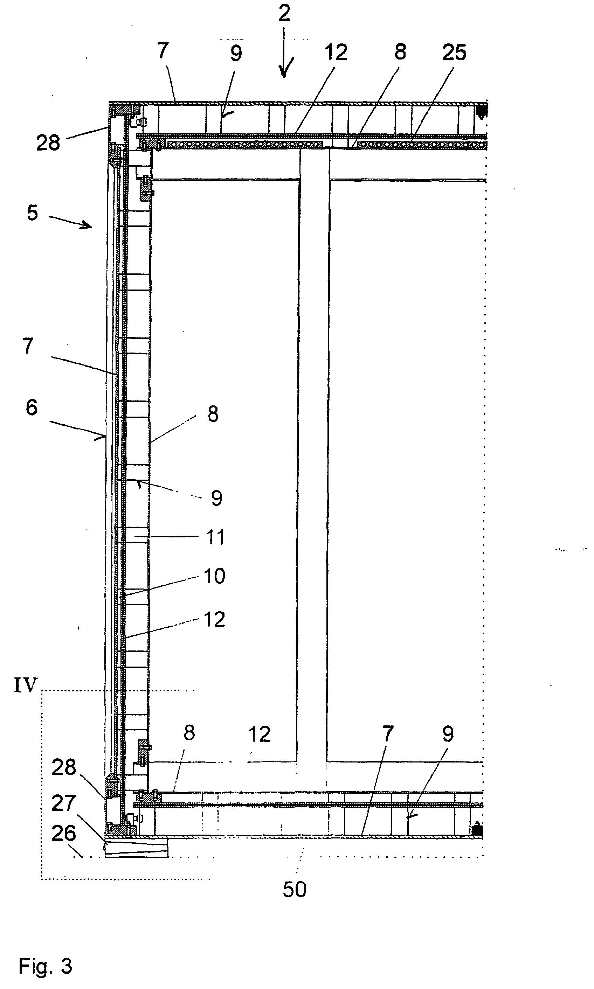

Fig. 3 zeigt die Hülle 5 im Aufriß gemäß der Schnittebene III-III der Fig. 2. Zur Vereinfachung der Zeichnung ist die Personalisierungseinrichtung weggelassen; auch die Ansichten der Eckprofile von innen sind nicht dargestellt. Man erkennt jedoch deutlich den Querschnittsaufbau der Seitenwandelemente 6 aus Außenschale 7, Innenschale 8 und den Abstandsbolzen 9 bzw. deren innere Abschnitte 11 und äußere.Abschnitte 10. Zwischen den beiden Abschnitten 10, 11 der Abstandsbolzen 9 ist eine Abschirmplatte 12 eingespannt. Das Dachelement 2 und das Bodenelement 50 besitzen einen entsprechenden Querschnittsaufbau. Im Dachelement befinden sich auf der Außenseite der Innenschale 8 Bündel von Kühlrohren 25, die der Regelung der Innentemperatur der Sicherheitszelle dienen. Die Außenschale 7 des Bodenelements 50 steht nicht flächig auf der strichpunktiert eingezeichneten Oberfläche 26 des Bodens des entsprechenden Aufstellungsraums, sondern ist über Keilschuhe 27 höhenverstellbar abgestützt. Derartige Keilschuhe 27 befinden sich zumindest in den Eckbereichen, aber auch dazwischen.

Sowohl in Bodenhöhe als auch im Bereich des Dachelements 2 sind im Querschnitt U-förmige, horizontal umlaufende Tragprofile 28 dargestellt, deren Profilsteg jeweils nach außen gerichtet ist und an deren Profilschenkeln Verbindungsleisten zur Befestigung der äußeren Wandschalen 7 vorgesehen sind. Letztere sind vergrößert dargestellt in Fig. 4, welche der Einzelheit IV in Fig. 3 entspricht. In Fig. 4 wird deutlich, daß die Verbindungsschrauben zur Befestigung der Verbindungsleisten auf der Außenseite der Hülle 5 nicht in Erscheinung treten. Der Profilträger 28 ist von seiner Innenseite her mittels Schrauben 29 einerseits mit einer oberen Verbindungsleiste 30, andererseits mit einer bodenseitigen Verbindungsleiste 31 verbunden. In Nuten der Verbindungsleisten befinden sich durchgehende Dichtungen 32, die der Absicherung des Vakuums im Zwischenraum 13 zwischen Außenschale 7 und Innenschale 8 dienen. Zur Ausrichtung und seitlichen Abstützung der Abschirmplatte 12 dient ein Anschlag in Form einer Stellschraube 33, die in einen Gewindeblock 34 eingeschraubt ist. Mittels der Stellschraube 33 wird das untere Ende der Abschirmplatte 12 gegen die Stirnseiten der beiden Schenkel des U-Profilträgers 28 angedrückt. Die mit den Bezugszeichen 31, 32, 50 und 9 versehenen Konstruktionselemente können alternativ durch einen Boden und Deckel ersetzt werden, bei dem die Formteile aus dem vollen Material gearbeitet sind, oder als Gußteile ausgeführt werden.

Dadurch, daß im Zwischenraum 13 ein Vakuum herrscht, so daß die Bolzen 9 unter Druckspannung stehen, genügt es, wenn deren Abschnitte 10, 11 in den zugeordneten Schalen der Hülle 5 jeweils durch einen Zentriervorsprung 35 lagefixiert sind.

Ein innerer U-Profilträger 36 ist ähnlich dem äußeren U-Profilträger 28 über eine obere Verbindungsleiste 37 und eine untere Verbindungsleiste 39 mit den angrenzenden Innenschalen 8 einerseits des Seitenelements 6, andererseits des Bodenelements 50 verbunden. Die Schrauben 29 sind in Gewindebuchsen 38 aus Stahl eingeschraubt, die eine bessere Tragfähigkeit haben als der Werkstoff Aluminium, aus welchem sämtliche Konstruktionsteile der Hülle wie Innenschale, Außenschale, U-Profilträger, Verbindungsleisten, Bolzen und dergleichen gefertigt sind.

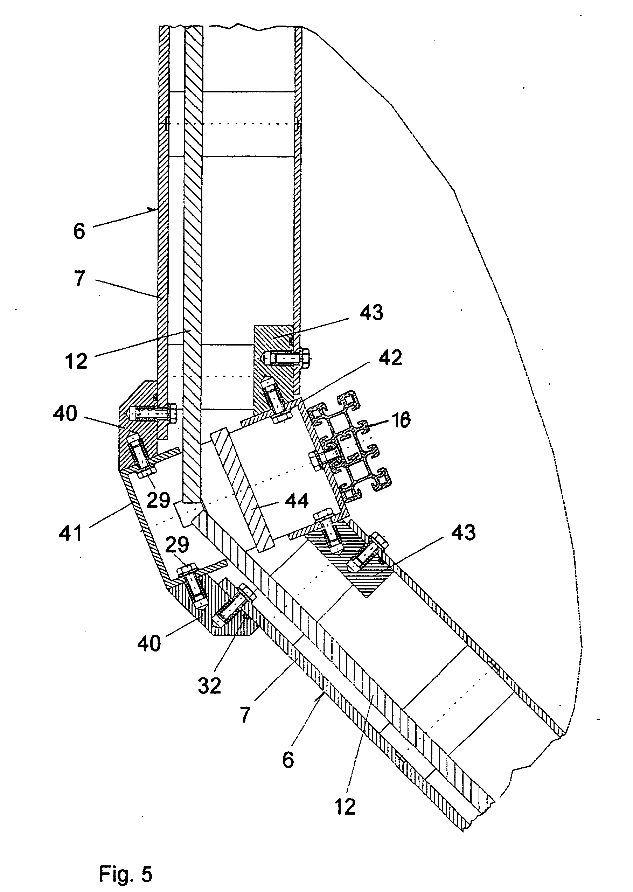

Die in Fig. 5 dargestellte Einzelheit V gemäß Fig. 1 zeigt im Detail den Anschluß zweier Wandelemente 6 an zwei vertikale U-Profilträger im Eckbereich. Die Außenschalen 7 sind mittels vertikaler Verbindungsleisten 40 und von innen eingeschraubter Schrauben 29 mit einem äußeren U-Profil 41 verbunden. Die beiden Innenschalen 8 sind mit einem inneren U-Profil 42 über entsprechende Verbindungsleisten 43 verschraubt. Bezüglich der Verschraubung und der Abdichtung dieser Verbindungen gilt das zur Fig. 4 Gesagte entsprechend. Zwei Abschirmplatten 12 treffen im Eckbereich aufeinander, wo sie zwischen sich einen Abstand lassen. Damit im Bereich dieses Abstands keine Abschirmlücke auftritt, befindet sich auf der Innenseite der vertikalen Stoßkante der beiden Abschirmplatten 12 ein schmaler Abschirmstreifen 44, welcher dafür sorgt, daß die Abschirmung gegen elektromagnetische Wellen und zur Erkennung einer Penetration auch im Eckbereich lückenlos gewährleistet ist.

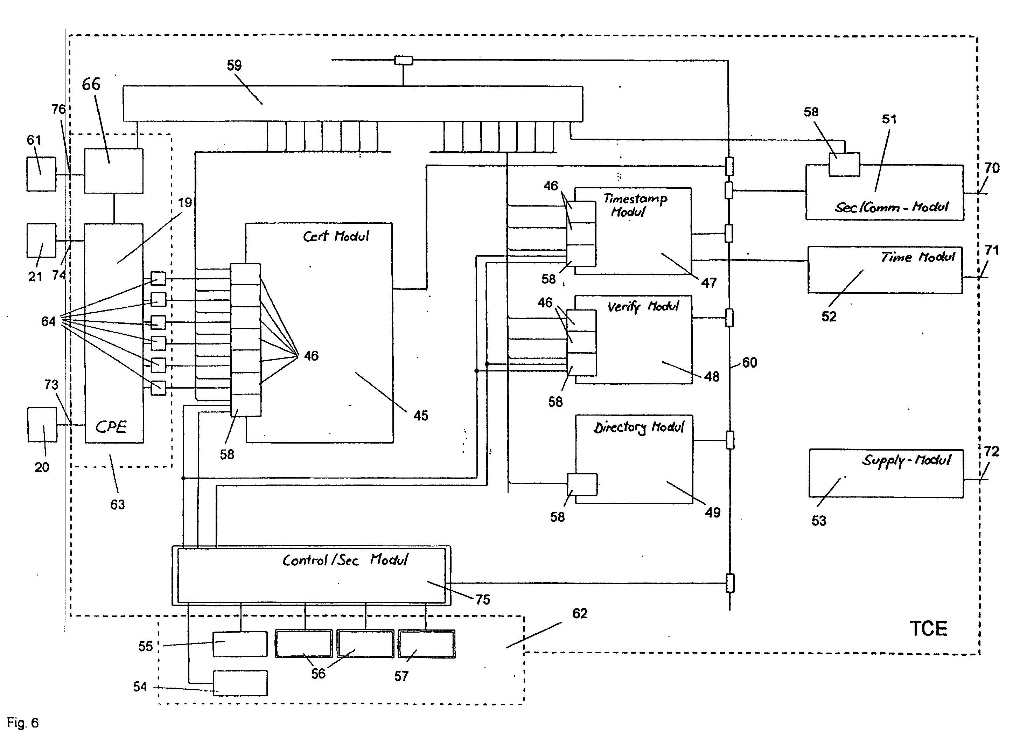

Fig. 6 zeigt ein Schaltbild der im Inneren der Sicherheitszelle angeordneten Module. Die elektrische Chipkartenpersonalisierung erfolgt in der Chipkarten-Personalisierungseinheit (CPE) 19 im Personalization Module 63, welches zusätzlich zur CPE auch noch deren Steuerung 66 enthält, die über das Interface 76 mit einer Signalisierungseinheit 61 für den Bediener der CPE verbunden ist. Die CPE ist mit mehreren Kontaktierstellen für Chipkarten ausgerüstet, von denen jede über einen Chipkarten-Coupler 64 mit einem Crypto-Modul 46 im Certification Module (Cert-Modul) 45 über eine abgeschirmte und zusätzlich in einem flexiblen Metallpanzerschlauch geführte Leitung direkt verbunden ist, um Beeinflussungen der Datenübertragung auf dieser Leitung zu vermeiden. Das Cert-Modul ist ein Industrierechner mit Netzwerkschnittstelle zum internen Kommunikationsnetz der TCE. In diesem Rechner sind die vorgenannten Crypto-Module als Steckkarten am Systembus eingebaut. Ebenfalls als Steckkarte ist ein lokales Security Module (SM) 58 im Rechner des Cert-Moduls eingebaut. Der Rechner des Cert-Moduls führt die zur Personalisierung von Chipkarten erforderlichen übergeordneten Funktionen aus. Zur Erstellung eines Certificates empfängt er die erforderlichen Registrationsdaten in Form eines Pre-Certificates, kommuniziert mit der Steuerung der CPE und veranlaßt diese, zu personalisierende Chipkarten an ihre Kontaktierstellen zu transportieren und nach erfolgter Personalisierung wieder auszustoßen. Zur Durchführung der eigentlichen Personalisierung leitet der Rechner im Cert-Modul das Pre-Certificate des Teilnehmers an ein Crypto-Modul weiter und beauftragt dieses Crypto-Modul mit der Personalisierung der Chipkarte in der ihm zugeordneten Kontaktierstelle der CPE. Der Rechner des Cert-Moduls kann die zur Personalisierung der Chipkarte erforderlichen Funktionen, welche im Crypto-Modul ausgeführt werden, nicht in ihrem korrekten Ablauf beeinflussen, da das Crypto-Modul ein eigenständiges Rechnersystem mit spezieller Hardware darstellt. Die Crypto-Module geben das signierte öffentliche Schlüsselzertifikat sowie die verschlüsselten Aktivierungs- und Sperr-PINs der personalisierten Chipkarte nach Abschluß der Personalisierung zurück zum Rechner des Cert-Moduls, welcher erstgenannte an einen Verzeichnisdienst (Directory Module) 49 und das Verification Module 48 übergibt und letztere über das Secure Communication Module 51 und die Schnittstelle zum externen Netzwerk der PKI 70 auf gesichertem Weg zum Besitzer der korrespondierenden personalisierten Chipkarte weiterleitet. Das lokale Security Module 58 hat die Aufgabe, durch entsprechende Signalisierung eines Aktivierungssignales ausgehend vom Control and Security Module (Control/Sec-Modul) 75 alle Crypto-Module des Cert-Moduls zum Betrieb freizugeben und im Falle der Anregung des ebenfails vom Control/Sec-Modul ausgehenden Signales "Sicherheitsabschaltung" alle Crypto-Module in den gesicherten Zustand zu überführen, in dem die Arbeitsspeicher gelöscht und die Signierschlüssel nur mehr in verschlüsselter Form vorhanden sind.

Über eine weitere serielle Schnittstelle, den Terminal-Server 59 und das interne Kommunikationsnetz der TCE kommuniziert jedes Crypto-Modul über das zentrale Control/Sec-Modul 75 als Leitungsmultiplexer direkt mit den Chipkartenlesern 56 des außen an der TCE angebrachten Access-Moduls 62. Über diese Verbindung erhält jedes Crypto-Modul beim Inbetriebsetzen der TCE durch direkte Kommunikation mit beiden Authentisierungs-Chipkarten der zwei Sicherheitspersonen von jeder dieser beiden Chipkarten jeweils eine Hälfte des Schlüssels, mit dem das Crypto-Modul dann in der Lage ist, die in ihm gespeicherten Signierschlüssel der TCE zu dechiffrieren und damit zu benutzen.

Das Control/Sec-Modul 75 ist zuständig für die übergeordnete Steuerung des Betriebs der TCE, welcher die getrennte Aktivierung der On-line-Dienste Timestamp-Dienst, Zertifikats-Verifikationsdienst, Zertifikats-Sperrdienst, realisiert durch die Module Timestamp-Modul 47 und Verify-Modul 48, und ggfs. auch des Verzeichnisdienstes, realisiert durch das Directory-Modul 49, und der Chipkartenpersonalisierung vorsieht. Außerdem sind im Control/Sec-Modul die Überwachungsfunktionen für die TCE realisiert. Hierzu sind an das Control/Sec-Modul unterschiedliche Sensoren und Schaltglieder sowie die Komponenten für die Kommunikation mit den und die Identifikation und Authentisierung der Sicherheitspersonen, die die TCE kontrollieren, angeschlossen, nämlich ein Keypad 54, eine Display-Einheit 55, zwei Access-Chipkartenleser 56 und ein Access-Biometric-System 57.

In den Modulen Timestamp-Modul 47 und Verify-Modul 48 sind ebenfalls Crypto-Module 46 eingebaut, da hier ebenfalls sicherheitskritische Operationen ausgeführt und Signaturschlüssel der TCE verwendet und gehalten werden. Zur Aktivierung dieser sicherheitskritischen Module der On-line-Dienste übermittelt das Control/Sec-Modul 75 ein entsprechendes, vom Aktivierungssignal für das Cert-Modul getrenntes Aktivierungssignal und ebenso das Signal "Sicherheitsabschaltung" mit gleicher Funktion wie im Cert-Modul.

In den SM-Modulen 58 ist das Gerätezertifikat des betreffenden Funktionsmoduls in Hardware enthalten und über die auf den SM-Modulen 58 realisierte eigenintelligente serielle Schnittstelle und den Terminal-Server 59 kommuniziert das Control and Security Module 75 über das interne Kommunikationsnetz mit dem Funktionsmodul.

In der TCE sind außerdem noch ein Supply-Modul 53 eingebaut, über welches die Spannungsversorgung und die Kühlung der TCE erfolgt, oder andere Versorgungsmedien zur Verfügung stellt. Elektrische Energie und/oder andere Versorgungsmedien werden dem Supply-Modul über die Schnittstelle 72 von außen zugeführt, und Wärme wird über diese Schnittstelle nach außen über Külmittelleitungen abgeführt.

Das Time-Modul 52 stellt eine elektronische hochgenaue Präzisionsuhr dar, welche über die Schnittstelle 71 von außerhalb der TCE synchronisierbar ist und ihre Zeitdaten dem Timestamp-Modul 47 zur Verfügung stellt.

## Patentansprüche

1. Trust-Center-Einheit (TCE) mit einer Sicherheitszelle (1) für den Betrieb einer Public-Key-Infrastruktur (PKI), welche eine Chipkarten-Personalisierungseinrichtung (CPE) umfaßt, mit den Merkmalen:
1.1 die Sicherheitszelle (1) besitzt eine Hülle (5) in Leichtbauweise für die Aufstellung in üblichen Büroräumen;
1.2 die Hülle (5) ist als doppelwandige Metallschale aus Seitenwand, Boden- und Deckenelement ausgebildet und bis auf eine Tür für den Zutritt im Wartungsfall sowie Durchführungen für Versorgungsanschlüsse (72), Datenverbindungsleitungen (70, 71, 76) für den Anschluß an das Kommunikationsnetz der PKI, die CPE (19) und ein außen gelegenes Access-Modul (62) vollkommen geschlossen;
1.3 die Hülle (5) der Sicherheitszelle (1) mit Durchführungen ist durch Überwachungssensoren gegen unerkanntes Eindringen gesichert;
1.4 auf der Innenseite der Hülle (5) ist ein Abschirmschutz vorgesehen, der einen Durchgang verwertbarer elektromagnetischer Wellen durch Hülle (5) und Durchführungen verhindert;
1.5 in dem von der Hülle (5) umschlossenen Innenraum (13) sind wenigstens alle sicherheitskritischen Funktionsmodule der TCE untergebracht;
1.6 die Funktionsmodule zur vollautomatischen, d.h. ohne menschliches Eingreifen, erfolgenden Realisierung der TCE-Funktionen sind an ein Kommunikationsnetzwerk angeschlossen;
1.7 eine Sicherheitsabschaltung, welche die sicherheitskritischen Informationen in den Funktionsmodulen beim Ansprechen der Überwachungssensoren automatisch in einen unbrauchbaren Zustand überführt.

2. TCE nach Anspruch 1,
**dadurch gekennzeichnet,**
**daß** die Hülle (5) im Grundriß ein Achteck beschreibt und die Seitenwand aus diesem zugeordneten Wandelementen besteht.

3. TCE nach Anspruch 2,
**dadurch gekennzeichnet,**
**daß** CPE (19), Tür (18) und Access-Modul jeweils einem Wandelement (6) der Seitenwand zugeordnet sind.

4. TCE nach Anspruch 1,
**dadurch gekennzeichnet,**
**daß** die Hülle (5) aus einer geschlossenen Außenschale (7) und einer Innenschale (8), jeweils aus hochfestem Aluminium gebildet ist.

5. TCE nach Anspruch 4,
**dadurch gekennzeichnet,**
**daß** die beiden Schalen der Hülle (5) durch eine Mehrzahl von über die Fläche der Wandelemente (6) verteilte Abstandsbolzen (9) oder Abstandsgitter gegeneinander abgestützt sind.

6. TCE nach Anspruch 4,
**dadurch gekennzeichnet,**
**daß** Boden- und Deckenelement jeweils durch eine Außenschale (7) und eine Innenschale (8) gebildet sind, die jeweils im Kantenbereich mittels Profilträgern an die Seitenwand angeschlossen sind.

7. TCE nach Anspruch 6,
**dadurch gekennzeichnet,**
**daß** die Anschlußkanten nach außen durch Profilleisten abgedeckt sind, welche im Falle der Außenschale von innen her mit dem Profilträger einerseits und der Außenschale andererseits verschraubt sind.

8. TCE nach Anspruch 1,
**dadurch gekennzeichnet,**
**daß** das Bodenelement (24) der Hülle (5) in deren Eckbereichen auf höhenverstellbaren Keilschuhen (27) abgestützt ist.

9. TCE nach Anspruch 1,
**dadurch gekennzeichnet,**
**daß** die Hülle (5) eine im wesentlichen aus ebenen Flächen gebildete Oberfläche aufweist, welche zur besseren optischen Erkennung ihrer Unversehrtheit hochglanzbehandelt ist.

10. TCE nach Anspruch 1,
**dadurch gekennzeichnet,**
**daß** im Zwischenraum (13) der die Hülle (5) bildenden doppelwandigen Metallschale eine über die gesamte Metallschale ausgebreitete, flächig wirksame Detektionseinrichtung zum Erkennen physischen Eindringens vorgesehen ist.

11. TCE nach Anspruch 10,
**dadurch gekennzeichnet,**
**daß** die Detektionseinrichtung aus einen Plattenkondensator bildenden Plattenelementen zusammengesetzt ist, welche derart angeordnet sind, daß sie ein lückenloses elektrisches Feld aufbauen, welches im Falle einer Penetrierung eines Plattenelements einen meßbaren Stromfluß erzeugt.

12. TCE nach Anspruch 10,
**dadurch gekennzeichnet,**
**daß** der Zwischenraum (13) gasdicht ausgebildet ist und dort ein Unterdruck aufrechterhalten wird, und daß Drucksensoren vorgesehen sind.

13. TCE nach Anspruch 12,
**dadurch gekennzeichnet,**
**daß** der Zwischenraum (13) ganz oder teilweise mit einem inerten Gas gefüllt ist und daß Gassensoren und Gasdrucksensoren vorgesehen sind.

14. TCE nach Anspruch 11,
**dadurch gekennzeichnet,**
**daß** Abstandsbolzen (9) oder Abstandsgitter auf beiden Seiten der Plattenelemente angeordnet sind.

15. TCE nach Anspruch 1,
**dadurch gekennzeichnet,**
**daß** bei Leitungsdurchführungen die Adern elektrischer Kabel auf Adernbruch, mediumgefüllte Leitungen auf Druckschwankung und/oder durch optische Sensoren überwacht werden.

16. TCE nach Anspruch 4,
**dadurch gekennzeichnet,**
**daß** eine Körperschallüberwachung mittels über die Innenschale (8) verteilt angeordneter Sensoren vorgesehen ist.

17. TCE nach Anspruch 11,
**dadurch gekennzeichnet,**
**daß** im Zwischenraum (13) zwischen Außen- und Innenschale eine über die gesamte Hülle (5) ausgebreitete Abschirmung gegen elektromagnetische Abstrahlung in Form von überlappend angeordneten Plattenelementen (12) aus Stahl oder anderen ferromagnetischen Materialien oder Folien aus hochpermeablen ferromagnetischen Materialien vorgesehen ist.

18. TCE nach Anspruch 1,
**dadurch gekennzeichnet,**
- **daß** Crypto-Module (46) ein autark arbeitendes Rechnersystem mit Spezialhardware und Sicherungsfunktionen bilden, welches für den Betrieb aller sicherheitskritischen Operationen, nämlich Schlüsselerzeugung, Einbringen der Schlüssel in Chipkarten, Signatur der Schlüsselzertifikate, Anbringen von Zeitstempeln, Verifikation von Teilnehmer-Registrierungsdaten, Signaturen von Listen gesperrter Zertifikate und Signaturen von Statusmeldungen über Zertifikate vorgesehen ist,
- **daß** die Crypto-Module mit diesen Operationen entsprechenden Funktionsmodulen datentechnisch kommunizieren, ohne jedoch über diese Kommunikationsschnittstellen beeinflußt zu werden und
- **daß** die Sicherungsfunktionen des Crypto-Moduls abhängig vom Signal "Sicherheitsabschaltung" oder von der Abschaltung der Spannungsversorgung, das Crypto-Modul unbrauchbar machen, indem die darin gespeicherten Signierschlüssel nur mehr verschlüsselt vorliegen oder gelöscht werden.

19. TCE nach Anspruch 8,
**dadurch gekennzeichnet,**
**daß** weitere Abschirmmaßnahmen darin bestehen, daß die Crypto-Module als solche mit Metall-Abschirmungen versehen sind, und daß die CPE, in der die Benutzerschlüssel auf die Chipkarte geschrieben werden, sowie die Funktionsmodule, in denen Crypto-Module verwendet werden, die ihrerseits Signierschlüssel des Trust Centers gespeichert halten und verwenden, als Gesamtheit mit einer Metall-Abschirmungskapsel umgeben sind, wobei alle Kommunikationsleitungen mit Filtern gegen leitungsgebundene elektromagnetische Felder versehen sind, so daß sich ein gestaffelter Schutz gegen Abstrahlung elektromagnetischer Felder ergibt.

20. TCE nach Anspruch 1,
**dadurch gekennzeichnet,**
**daß** zur Überprüfung der Integrität der Hardware-Module bei geöffneter Sicherheitszelle sämtliche Module mit Plomben für die Sichtprüfung und mit Chipkartenlesern für die Verifikation der Modulversionen anhand der eingebrachten Gerätezertifikate und zur Verifikation der Software mit speziellen Authentisierungscodes versehen sind.

21. TCE nach Anspruch 1,
**dadurch gekennzeichnet,**
**daß** die Zugangskontrolle an der Tür (18) derart ausgeführt ist, daß sie sich dann bestimmungsgemäß öffnen läßt, wenn zwei Sicherheitspersonen sich über Zertifikate in einem persönlichen Hardware-Token, insbesondere einer Chipkarte, welche sie den dafür vorgesehenen Leseeinrichtungen, insbesondere Chipkartenlesern, im Access-Modul zuführen, einen persönlichen Code eingeben und eine Identifizierung durch ein biometrisches Verfahren durchführen.

22. TCE nach Anspruch 1,
**dadurch gekennzeichnet,**
**daß** bei nicht bestimmungsgemäßen Öffnungsversuchen die Sicherheitsabschaltung eingeleitet wird.

23. TCE nach Anspruch 1,
**dadurch gekennzeichnet;**
**daß** bei unterbrochener Energieversorgung und nachfolgender Wiederkehr der Energieversorgung gesichert feststellbar ist, ob die Tür (18) seit dem Verlassen des ungestörten Betriebszustands geöffnet wurde.

24. Verfahren zum Betrieb einer TCE gemäß Anspruch 1,
**dadurch gekennzeichnet,**
- **daß** die TCE aufgrund eines eingebauten Verriegelungsmechanismus nur dann in Betrieb genommen werden kann, wenn es menschenleer ist, wenn alle Sicherheitsfunktionen korrekt arbeiten und keine Störungen an Funktionsmodulen detektiert werden,
- **daß** die TCE nur dann ohne zusätzliche Verifikation der Integrität ihrer Komponenten in Betrieb genommen werden kann, wenn die Türe seit dem Verlassen des ungestörten Betriebszustandes nicht geöffnet wurde,
- **daß** die TCE, nachdem die Tür geöffnet wurde, oder die Überwachungssensoren angesprochen haben, nur dann in Betrieb gesetzt werden kann, wenn zuvor die Integrität und Authentizität der Hardware aller eingebauter Module festgestellt wurde und die Software zumindest aller sicherheitskritischen Funktionen durch Überprüfung ihres MAC-Codes als korrekt verifiziert oder aus gesicherter Quelle neu eingespielt wurde und
- **daß** jegliches Ansprechen der Überwachungssensoren die Sicherheitsabschaltung der TCE auslöst.

25. Verfahren nach Anspruch 24,
**dadurch gekennzeichnet,**
- **daß** zur elektrischen Personalisierung von Personal Security Environments (PSE) auf der Basis von Hardware-Tokens, insbesondere Chipkarten, asymmetrische Schlüsselpaare innerhalb der TCE unter kontrollierten Bedingungen in einer Spezialhardware erzeugt werden;
- **daß** der geheime Schlüssel eines Schlüsselpaares abhörsicher erzeugt und in das Hardware-Token eingebracht wird,
- **daß** der geheine Schlüssel dem seinen Besitzer kennzeichnenden Daten zugeordnet wird und diese Zuordnung in einem Zertifikat der TCE bestätigt wird, welches zumindest den korrespondierenden öffentlichen Schlüssel und die kennzeichnenden Daten des Besitzers enthält und in das Hardware-Token eingebracht wird,
- **daß** die Zuführung und Abführung der Hardware-Token vollautomatisch von außerhalb der TCE erfolgt,
- **daß** für jedes Hardware-Token bei der Personalisierung ein eindeutiger Aktivierungscode generiert und in das Hardware-Token eingebracht wird, dessen Kenntnis erforderlich ist, um das Hardware-Token zu aktivieren,
- daß der Aktivierungscode für das Hardware-Token von der TCE gesichert und geheim dem Empfänger des Hardware-Tokens übermittelt wird und
- **daß** für jedes personalisierte Hardware-Token ein eindeutiger Sperrcode generiert wird, der sowohl in der TCE gespeichert bleibt als auch dem Empfänger des Hardware-Tokens gesichert übermittelt wird.

26. Verfahren nach Anspruch 25,
**dadurch gekennzeichnet,**
- **daß** zur Schlüsselerzeugung asymmetrische Schlüsselpaare im Crypto-Modul unter kontrollierten Umgebungsbedingungen erzeugt werden,
- **daß** asymmetrische Schlüsselpaare im Crypto-Modul abhörsicher erzeugt werden,
- **daß** der geheime Schlüssel in das Hardware-Token geladen wird, sobald sich ein zu personalisierendes Hardware-Token in der zugeordneten Kontaktierposition in der CPE befindet,
- **daß** das Crypto-Modul für jedes erzeugte Schlüsselpaar prüft, ob das Schlüsselpaar identisch mit einem vorher erzeugten ist,
- **daß** nach dem Schreiben des geheimen Schlüssels auf das Hardware-Token die Sicherheitsfunktionen des Hardware-Token gegen Auslesen und Überschreiben des Schlüssels aktiviert werden und
- **daß** die für die Schlüsselerzeugung verwendeten flüchtigen Speicher beim Ansprechen des Signals "Sicherheitsabschaltung" oder dem Abschalten der Versorgungsspannung zurückgesetzt werden.

## Claims

1. A trust centre unit (TCU) with a security cell (1) for operating a public-key infrastructure (PKI) containing a chip card personalising device (CPD), having the following characteristics:
1.1 the security cell (1) has a light-construction envelope (5) for erection in public offices with leadthroughs to internal equipment;
1.2 the envelope (5) is designed as a double-walled metal shell comprising side wall, base and cover elements, and is completely closed except for a door used for access during maintenance, as well as leadthroughs for supply terminals (72), data connection lines (70, 71, 76) for connecting to the telecommunications network of the PKI, the CPD (19) and an externally connected access module (62).
1.3 the envelope (5) of the security cell (1) with leadthroughs is protected by monitoring sensors against undetected penetration;
1.4 provided on the interior of the envelope (5) is a protective screen which prevents the penetration through the envelope (5) and leadthroughs of electromagnetic waves which can be evaluated;
1.5 at least all security-critical components of the TCU are housed in the interior (13) enclosed by the envelope (5);
1.6 the components enabling fully automatic execution of the TCU functions, that is, without human intervention, are connected to a telecommunications network;
1.7 security shutdown which automatically sets the security-critical information in the components into an unusable state if the monitoring sensors respond.

2. The TCU as claimed in Claim 1,
**characterised in that**
the envelope (5) is octagonal in plan and the side wall comprises these assigned wall elements.

3. The TCU as claimed in Claim 2,
**characterised in that**
CPD (19), door (18) and access module are each assigned to a wall element (6) of the side wall.

4. The TCU as claimed in Claim 1,
**characterised in that**
the envelope (5) is designed from a closed outer shell (7) and an inner shell (8), each made of high-strength aluminium.

5. The TCU as claimed in Claim 4,
**characterised in that**
both shells of the envelope (5) are supported relative to one another by a plurality of spacer bolts (9) or spacer grids distributed over the surface of the wall elements (6).

6. The TCU as claimed in Claim 4,
**characterised in that**
base and cover element are each formed by an outer shell (7) and an inner shell (8) which are each attached to the side wall in the edge region by means of profiled brackets.

7. The TCU as claimed in Claim 6,
**characterised in that**
the attaching edges are covered outwardly by profiled strips which in the case of the outer shell are screwed from the inside to the profiled bracket on one side and the outer shell on the other side.

8. The TCU as claimed in Claim 1,
**characterised in that**
the base element (24) of the envelope (5) is supported in its corner regions on height-adjustable wedge shoes (27).

9. The TCU as claimed in Claim 1,
**characterised in that**
the envelope (5) exhibits a top surface formed essentially from flat surfaces, and is very brightly plated for better optical recognition of its integrity.

10. The TCU as claimed in Claim 1,
**characterised in that**
provided in the cavity (13) of the double-walled metal shell forming the envelope (5) is a planar, effective detection device for recognising physical penetration, spread over the entire metal shell.

11. The TCU as claimed in Claim 10,
**characterised in that**
the detection device comprises plate elements forming a plate condenser, which are arranged such that they build up a continuous electrical field which generates a measurable current flow in the event a plate element is penetrated.

12. The TCU as claimed in Claim 10,
**characterised in that**
the cavity (13) is designed gas-tight and a subpressure is maintained there, and **in that** pressure sensors are provided.

13. The TCU as claimed in Claim 12,
**characterised in that**
the cavity (13) is filled fully or partially with an inert gas and **in that** gas sensors and gas pressure sensors are provided.

14. The TCU as claimed in Claim 11,
**characterised in that**
spacer bolts (9) or spacer grids are arranged on both sides of the plate elements.

15. The TCU as claimed in Claim 1,
**characterised in that**
in the case of wire leadthroughs the leads of electrical cables are monitored for breakage, while medium-filled wires are monitored for fluctuations in pressure and/or by optical sensors.

16. The TCU as claimed in Claim 4,
**characterised in that**
the body shell is monitored by means of sensors distributed over the inner shell (8).

17. The TCU as claimed in Claim 11,
**characterised in that**
provided in the cavity (13) between outer and inner shell is shielding against electromagnetic radiation spread over the entire envelope (5) in the form of overlapping plate elements (12) made of steel or other ferromagnetic materials or films made of high-permeable ferromagnetic materials.

18. The TCU as claimed in Claim 1,
**characterised in that**
- crypto-modules (46) form a self-sufficient computing system with special hardware and security functions, which is provided to run all security-critical operations, namely key production, incorporating of keys into chip cards, signature of the key certificates, fixing of time stamps, verification of subscriber registration data, signatures of lists of barred certificates and signatures of status messages on certificates,
- **in that** the crypto-modules communicate by way of data technology with functional modules corresponding to these operations, though without being influenced by these communication interfaces, and
- **in that** the security functions of the crypto-module render the crypto-module unusable independently of the "security shutdown" signal or of shutdown of the voltage supply, **in that** the signal keys stored therein are no longer available in encoded form or are deleted.

19. The TCU as claimed in Claim 8,
**characterised in that**
further shielding measures comprise the fact that the crypto-modules as such are equipped with metal shielding, and **in that** the CPD, in which the user keys are written on the chip card, as well as the functional modules, in which crypto-modules are used, which for their part store and utilise signal keys of the trust centre, are surrounded in their entirety by a metal shielding capsule, in such a way that all communication lines are provided with filters against guided electromagnetic fields, resulting in graduated protection against radiation of electromagnetic fields.

20. The TCU as claimed in Claim 1,
**characterised in that**
all modules are provided with seals for spot-checking and with chip card readers for verification of the module versions with reference to the introduced unit certificates and for verification of the software with special authentication codes for checking the integrity of the hardware modules when the security cell is open.

21. The TCU as claimed in Claim 1,
**characterised in that**
the access control on the door (18) is designed such that it can be opened appropriately if two security personnel each input a personal code and complete an identification procedure utilising a biometric procedure by way of certificates in a personal hardware token, in particular a chip card, which they supply to the readers provided for this reason, in particular chip card readers, in the access module.

22. The TCU as claimed in Claim 1,
**characterised in that**
the security shutdown is initiated when unauthorised attempts to open it are made.

23. The TCU as claimed in Claim 1,
**characterised in that**
in the event of the power supply being interrupted and subsequent reconnection of the power supply it is definitely ascertained whether the door (18) has been opened since the undisturbed operating status was abandoned.

24. A process for operating a TCU as claimed in Claim 1,
**characterised in that**
- due to an inbuilt locking mechanism the TCU can be started up only if it is devoid of people, if all security functions are working correctly and if no interruptions to components are detected,
- **in that** the TCU, without additional verification of the integrity of its components, can be started up only if the door has not been opened since the undisturbed operating status was abandoned,
- **in that**, after the door was opened or the monitoring devices have responded, the TCU can be started up only if the integrity and authenticity of the hardware of all inbuilt modules was ascertained previously and the software of at least all security-critical functions was verified as correct by checking of their MAC code or was newly actuated from a secure source, and
- **in that** any response by a monitoring device triggers a security shutdown of the TCU.

25. The process as claimed in Claim 24,
**characterised in that**
- asymmetrical key pairs are produced inside the TCU under controlled conditions in special hardware for electronic personalisation of personal security environments (PSE) on the basis of hardware tokens, in particular chip card tokens;
- **in that** the secret key of a key pair is produced encrypted and incorporated into the hardware token,
- **in that** the secret key is allocated to the data recognising its owner and this assignation is confirmed in a TCU certificate containing at least the corresponding public key and the **characterising** data of the owner and incorporated into the hardware token,
- **in that** the hardware tokens are supplied and removed fully automatically from outside the TCU,
- **in that** a unique activation code is generated for each hardware token during the personalisation procedure and incorporated into the hardware token, whose knowledge is required to activate the hardware token,
- **in that** the activation code for the hardware token is transmitted securely and secretly to the recipient of the hardware token by the TCU, and
- **in that** for each personalised hardware token a unique bar code is generated, which remains stored in the TCU and is also transmitted securely to the recipient of the hardware token.

26. The process as claimed in Claim 25,
**characterised in that**
- asymmetrical key pairs are produced in the crypto-module under controlled environmental conditions for key production,
- **in that** asymmetrical key pairs are produced encrypted in the crypto-module,
- **in that** the secret key is loaded into the hardware token, as soon as a hardware token to be personalised is located in the assigned contact position in the CPD,
- **in that** the crypto-module for each key pair which has been produced checks whether the key pair is identical to one previously produced,
- **in that** after the secret key is written onto the hardware token the security functions of the hardware token are activated against read-out and overwriting of the key, and
- **in that** the volatile memories used for key production are restored when the "security shutdown" signal responds or when the supply voltage is switched off.

## Revendications

1. Unité de centre d'authentification (UCA) avec une cellule de sécurité (1) pour l'exploitation d'une infrastructure à clé publique (ICP) qui présente un système de personnalisation à carte à puces (SPCP), avec les caractéristiques suivantes :
1.1 la cellule de sécurité (1) possède un bâti (5) de construction légère à installer dans les locaux de bureaux habituels ;
1.2 le bâti (5) est formé d'une coque métallique à double paroi comportant une paroi latérale, un élément de sol et un de plafond ainsi qu'une porte permettant d'y accéder pour la maintenance et que des voies de passage pour des lignes d'alimentation (72), des lignes de liaison (70, 71, 76) pour le raccordement au réseau de communications de l'ICP, le SPCP (19) et un module d'accès (62) placé à l'extérieur et est complètement fermé ;
1.3 le bâti (5) de la cellule de sécurité (1) et ses voies de passage est protégé contre toute intrusion non reconnue par des capteurs de surveillance ;
1.4 sur la face interne du bâti (5), est prévue une protection isolante qui empêche le passage d'ondes électromagnétiques exploitables à travers le bâti (5) et ses voies de passage ;
1.5 dans l'espace intérieur (13) cerné par le bâti (5) sont installés au moins tous les modules fonctionnels critiques du point de vue de la sécurité de l'UCA.
1.6 les modules fonctionnels pour une réalisation entièrement automatique, c'est-à-dire sans intervention humaine, des fonctions de l'UCA sont raccordés à un réseau de communication ;
1.7 un arrêt de sécurité qui rend automatiquement inexploitables les informations critiques du point de vue de la sécurité dans les modules fonctionnels lors de la sollicitation des capteurs de surveillance.

2. UCA selon la revendication 1,
**caractérisée en ce que**
le bâti (5) présente, en vue en plan, une forme octogonale et que la paroi latérale est constituée de ces éléments associés de paroi.

3. UCA selon la revendication 2,
**caractérisée en ce que**
au SPCP (19), à la porte (18) et au module d'accès est respectivement associé un élément de paroi (6) de la paroi latérale.

4. UCA selon la revendication 1,
**caractérisée en ce que**
le bâti (5) est constitué d'une coque externe fermée (7) et d'une coque interne (8) respectivement en aluminium à haute résistance.

5. UCA selon la revendication 4,
**caractérisée en ce que**
les deux coques du bâti (5) sont tenues l'une contre l'autre par une pluralité de goujons d'écartement (9) ou grilles d'écartement répartis sur la surface des éléments de paroi (6).

6. UCA selon la revendication 4,
**caractérisée en ce que**
les éléments de sol et de plafond sont respectivement formés par une coque externe (7) et une coque interne (8) qui sont respectivement raccordées dans la zone des arêtes à la paroi latérale au moyen de supports profilés.

7. UCA selon la revendication 6,
**caractérisée en ce que**
les arêtes de raccordement sont recouvertes vers l'extérieur de baguettes profilées qui sont vissées de l'intérieur, dans le cas de la coque externe, d'une part au support profilé et d'autre part à la coque externe.

8. UCA selon la revendication 1,
**caractérisée en ce que**
l'élément de sol (24) du bâti (5) s'appuie à ses angles sur des sabots de calage (27) réglables en hauteur.

9. UCA selon la revendication 1,
**caractérisée en ce que**
le bâti (5) présente une surface globalement composée d'étendues planes, qui comporte un revêtement brillant permettant une meilleure reconnaissance optique de son intégrité.

10. UCA selon la revendication 1,
**caractérisée en ce que**
dans l'espace intermédiaire (13) de la coque métallique à double paroi formant le bâti (5), est prévu un dispositif de détection s'étendant sur toute la coque métallique et efficace en surface afin de reconnaître toute intrusion physique.

11. UCA selon la revendication 10,
**caractérisée en ce que**
le dispositif de détection est composé de plaques formant un condensateur plat qui sont disposées de manière à créer un champ électrique continu qui, en cas de pénétration d'une plaque, produit un flux de courant pouvant être mesuré.

12. UCA selon la revendication 10,
**caractérisée en ce que**
l'espace intermédiaire (13) est étanche aux gaz et qu'une dépression y est maintenue, et que des capteurs de pression sont prévus.

13. UCA selon la revendication 12,
**caractérisée en ce que**
l'espace intermédiaire (13) est rempli totalement ou partiellement d'un gaz inerte et que des capteurs de gaz et des capteurs de pression de gaz sont prévus.

14. UCA selon la revendication 11,
**caractérisée en ce que**
des goujons d'écartement (9) ou des grilles d'écartement sont disposés sur les deux faces des plaques.

15. UCA selon la revendication 1,
**caractérisée en ce que**
sur les voies de passage des lignes, les veines des câbles électriques sont surveillées pour vérifier l'absence de rupture, tout comme les variations de pression des conduites remplies de fluides, et/ou surveillées par des capteurs optiques.

16. UCA selon la revendication 4,
**caractérisée en ce que**
une surveillance phonique du corps est assurée au moyen de capteurs répartis sur la coque interne (8).

17. UCA selon la revendication 11,
**caractérisée en ce que**
dans l'espace intermédiaire (13) entre les coques externe et interne, une isolation contre le rayonnement électromagnétique répartie sur tout le bâti (5) est intégrée sous la forme de plaques (12) disposées en recouvrement en acier ou autres matières ferromagnétiques ou en feuillards de matière ferromagnétique très perméable.

18. UCA selon la revendication 1,
**caractérisée en ce que**
- des crypto-modules (46) forment un système numérique fonctionnant en autarcie avec un matériel informatique spécial et des fonctions de sécurité, qui est prévu pour gérer toutes les opérations critiques au point de vue de la sécurité, à savoir la création de clés, l'intégration des clés dans des cartes à puces, la signature des certificats de clés, l'apposition de timbres à dates, la vérification des données d'enregistrement des participants, les signatures de listes de certificats bloqués et les signatures de signalement d'états par des certificats,
- les crypto-modules communiquent au niveau des données techniques avec des modules fonctionnels correspondant à ces opérations, mais sans être influencés par ces interfaces de communication et
- les fonctions de sécurité du crypto-module rendent le crypto-module inexploitable en fonction du signal « arrêt de sécurité » ou de l'arrêt de l'alimentation électrique, du fait que les clés de signature qui y sont enregistrées ne sont plus disponibles que sous forme verrouillée ou sont effacées.

19. UCA selon la revendication 8,
**caractérisée en ce que**
d'autres mesures de protection consistent à munir les crypto-modules en tant que tels de protections métalliques et entourer l'ensemble des CPA, dans lesquels les clés des utilisateurs sont inscrites sur la carte à puce, ainsi que les modules fonctionnels dans lesquels des crypto-modules sont utilisés, gardant de leur côté en mémoire l'enregistrement des clés de signature de l'UCA et les utilisant, d'une capsule métallique de protection, toutes les lignes de communication étant munies de filtres contre les champs électromagnétiques liés à la ligne, afin d'obtenir une protection échelonnée contre le rayonnement des champs électromagnétiques.

20. UCA selon la revendication 1,
**caractérisée en ce que**
pour contrôler l'intégrité des modules matériels lorsque la cellule de sécurité est ouverte, tous les modules sont équipés de plombs pour le contrôle visuel et de lecteurs de cartes à puces pour la vérification des versions de modules sur la base des certificats d'appareils insérés et pour la vérification du logiciel avec des codes spéciaux d'authentification.

21. UCA selon la revendication 1,
**caractérisée en ce que**
le contrôle d'accès à la porte (18) est conçu de manière à ce qu'elle s'ouvre de manière conforme lorsque deux personnes de la sécurité se présentent par l'intermédiaire de certificats inclus dans une marque matérielle personnelle, en particulier une carte à puces, qu'ils introduisent dans les dispositifs de lecture prévus à cet effet, en particulier des lecteurs de cartes à puces du module d'accès, saisissent un code personnel et procèdent à une identification par procédé biométrique.

22. UCA selon la revendication 1,
**caractérisée en ce que**
en cas de tentatives d'ouverture non conformes, un arrêt de sécurité intervient.

23. UCA selon la revendication 1,
**caractérisée en ce que**
en cas d'interruption de l'alimentation électrique et de restauration consécutive de celle-ci, on peut constater avec sûreté si la porte (18) a été ouverte depuis que le fonctionnement a été perturbé.

24. Procédé pour l'exploitation d'une UCA selon la revendication 1,
**caractérisé en ce que**
- l'UCA ne peut être mise en service, en raison d'un mécanisme intégré de verrouillage, que si personne ne se trouve à l'intérieur, si toutes les fonctions de sécurité fonctionnement correctement et si aucune anomalie n'est décelée dans les modules fonctionnels,
- l'UCA ne peut être mise en service sans vérification supplémentaire de l'intégrité de ses composantes que si la porte n'a pas été ouverte depuis que le fonctionnement a été perturbé,
- l'UCA, une fois que la porte a été ouverte ou que les capteurs de surveillance ont réagi, ne peut être mise en service que si l'intégrité et l'authenticité au niveau matériel de tous les modules intégrés ont d'abord été établies et que le logiciel d'au moins toutes les fonctions critiques au niveau de la sécurité a été contrôlé comme correct par vérification de son code MAC ou a été remis au point en partant d'une source sûre et
- toute sollicitation des capteurs de surveillance déclenche l'arrêt de sécurité de l'UCA.

25. Procédé selon la revendication 24,
**caractérisé en ce que**
- pour la personnalisation électrique des environnements en sécurité personnelle (ESP) basés sur des marques matérielles, en particulier des cartes à puces, des paires de clés asymétriques sont élaborées au sein de l'UCA dans des conditions contrôlées dans un équipement informatique spécial ;
- la clé secrète d'une paire de clés est élaborée de manière insaisissable et intégrée dans la marque matérielle ;
- la clé secrète est associée aux données identifiant son possesseur et que cette association est confirmée dans un certificat de l'UCA qui comporte au moins la clé publique correspondante et les données d'identification du possesseur et est intégré dans la marque matérielle ;
- l'introduction et l'éjection de la marque matérielle hors de l'UCA se fait de manière entièrement automatique,
- pour chaque marque matérielle, lors de la personnalisation, un code d'activation sans équivoque dont la connaissance est nécessaire pour activer la marque matérielle est généré et intégré dans la marque matérielle,
- le code d'activation pour la marque matérielle est sécurisé par l'UCA et transmis confidentiellement au destinataire de la marque matérielle et
- pour chaque marque matérielle personnalisée, un code de blocage sans équivoque qui à la fois reste en mémoire dans l'UCA et est transmis sous forme sécurisée au destinataire de la marque matérielle est généré.

26. Procédé selon la revendication 25,
**caractérisé en ce que**
- pour l'élaboration d'une clé, des paires de clés asymétriques sont créées dans le crypto-module dans des conditions contrôlées d'environnement,
- des paires de clés asymétriques sont créées de manière insaisissable dans le crypto-module,
- la clé secrète est chargée dans la marque matérielle dès qu'une marque matérielle à personnaliser se trouve dans la position de contact associée dans le SPCP,
- le crypto-module vérifie, pour chaque paire de clés créée, si la paire de clés est identique à une de celle élaborée précédemment,
- après l'inscription de la clé secrète sur la marque matérielle, les fonctions de sécurité de la marque matérielle sont activées pour empêcher une lecture et un écrasement de la clé et
- les mémoires volatiles utilisées pour la création de clés sont réinitialisées lors de l'intervention du signal « arrêt de sécurité » ou de la mise hors tension électrique.
